(19) Europäisches Patentamt

European Patent Office

Office européen des brevets

(11) EP 0 750 206 A2

## (12) EUROPÄISCHE PATENTANMELDUNG

(43) Veröffentlichungstag:
27.12.1996 Patentblatt 1996/52

(51) Int. Cl.6: G02B 26/02

(21) Anmeldenummer: 96108176.7

(22) Anmeldetag: 22.05.1996

(84) Benannte Vertragsstaaten:
DE FR GB IT

(30) Priorität: 19.06.1995 DE 19522166

(71) Anmelder: SIEMENS AKTIENGESELLSCHAFT
80333 München (DE)

(72) Erfinder: Späth, Werner, Dipl.-Phys.
83607 Holzkirchen (DE)

### (54) Optischer Schalter

(57) Die Erfindung bezieht sich auf einen optischen Schalter mit einer optischen Übertragungsstrecke (2), die ein optisches Übertragungsmedium (3) aufweist, einer dem eingangsseitigen Ende (4) der optischen Übertragungsstrecke (2) zugeordneten Strahlungsquelle (5) zum Aussenden eines primären optoelektrischen Signals (6), welches in die Übertragungsstrecke (2) eingekoppelt wird, und einer dem ausgangsseitigen Ende (7) der Übertragungsstrecke (2) zugeordneten Reflexionseinrichtung (8), an welche das primäre optoelektronische Signal (6) zugeführt und in die Übertragungsstrecke (2) zurück reflektiert wird. Die Erfindung zeichnet sich dadurch aus, daß die Reflexionseinrichtung (8) das primäre optoelektronische Signal (6) in ein sekundäres moduliertes optoelektronisches Signal (9) wandelt, das sekundäre modulierte optoelektronische Signal (9) in die optische Übertragungsstrecke (2) zurück einkoppelt und an einen dem eingangsseitigen Ende (4) der Übertragungsstrecke (2) zugeordneten Empfänger (10) überträgt, der auf das sekundäre modulierte optoelektronische Signal (9) zur Ausführung eines elektronischen Schaltvorgangs anspricht. Die Erfindung besitzt insbesondere den Vorteil, daß das optische Übertragungsmedium (3) der optischen Übertragungsstrecke (2) mit lediglich einer einzigen Faser auskommt.

FIG 1

**Beschreibung**

Die vorliegende Erfindung bezieht sich auf einen optischen Schalter mit einer optischen Übertragungsstrecke, die ein optisches Übertragungsmedium aufweist, einer dem eingangsseitigen Ende der optischen Übertragungsstrecke zugeordneten Strahlungsquelle zum Aussenden eines primären optoelektrischen Signals, welches in die Übertragungsstrecke eingekoppelt wird, und einer dem ausgangsseitigen Ende der Übertragungsstrecke zugeordneten Reflexionseinrichtung, an welche das primäre optoelektronische Signal zugeführt und in die Übertragungsstrecke zurück reflektiert wird.

Ein derartiger optischer Schalter ist bekannt, der mit zwei Lichtwellenleitern arbeitet, und zwar mit einer Faser für den Hinweg und einer Faser für den Rückweg des optoelektronischen Signales. Beim Schaltvorgang wird hierbei in der Regel die Lage eines geeignet gestalteten Reflektors so verändert, daß er entweder das Lichtsignal aus der einen Faser in die jeweils andere Faser einkoppelt, oder eine bereits bestehende Einkopplung des Lichtsignals unterbricht.

Ganz allgemein ist es heute eine vielgenutzte Technik, Daten und auch Energie vermittels Photonen leitungsgebunden oder über Luft zu übertragen. Von der einfachen IR-Fernsteuerung über die optische Energieversorgung von Sensoren über Glasfaser bis hin zur optischen Nachrichtentechnik reichen hierbei die Anwendungen. Eine bidirektionale Übertragung von Daten und eine gleichzeitige Übertragung von Energie zwischen einem Lesegerät und einem Datenträger sind seit längerer Zeit bekannt und vom Prinzip her technisch möglich, jedoch hat bislang ein breiterer Einsatz dieser Technik nicht stattgefunden.

Der Erfindung liegt die Aufgabe zugrunde, einen optischen Schalter in der Form eines monolithischen Bauelementes zur Verfügung zu stellen, welcher einen breiteren Einsatz dieser Technik als bisher, insbesondere auf dem Gebiet des optischen Kontaktierens eines Identifizierungssystems oder einer Chip-Karte ermöglicht.

Diese Aufgabe wird durch einen optischen Schalter gemäß Anspruch 1 gelöst.

Der erfindungsgemäße optische Schalter zeichnet sich dadurch aus, daß die dem ausgangsseitigen Ende der Übertragungsstrecke zugeordnete Reflexionseinrichtung so ausgebildet ist, daß das in die Übertragungsstrecke eingekoppelte primäre optoelektronische Signal in ein sekundäres, moduliertes optoelektronisches Signal umgewandelt wird, welches sekundäre optoelektronische Signal in die Übertragungsstrecke zurück eingekoppelt und an den Empfänger am eingangsseitigen Ende der Übertragungsstrecke übertragen wird, der auf das sekundäre, modulierte optoelektronische Signal zur Ausführung eines elektronischen Schaltvorgangs anspricht.

Als besonderer Vorteil der Erfindung wird es ermöglicht, daß der Schaltvorgang vermittels einer einzigen Faser bewerkstelligt werden kann.

Bei einer bevorzugten Ausgestaltung der Erfindung ist dem am eingangsseitigen Ende der Übertragungsstrecke angeordneten Empfänger eine optoelektronische Trennvorrichtung zugeordnet, welche auf das primäre optoelektronische Signal der Strahlungsquelle und das sekundäre, modulierte optoelektronische Signal von der Reflexionseinrichtung unterschiedlich anspricht. Hierbei kann insbesondere vorgesehen sein, daß dem Empfänger ein optoelektronisches Filter vorgeschaltet ist, welches im wesentlichen lediglich für das sekundäre, modulierte optoelektronische Signal durchlässig ist.

Bei einer bevorzugten Ausgestaltung der Erfindung kann insbesondere vorgesehen sein, daß dem am eingangsseitigen Ende der Übertragungsstrecke angeordneten Empfänger ein Schaltkreis zugeordnet ist, der als Reaktion auf das vom Empfänger erfaßte sekundäre, modulierte optoelektronische Signal ein Steuersignal zur Ausführung des elektronischen Schaltvorgangs ableitet.

Bei einer besonders bevorzugten Ausbildung der Erfindung kann das von der Reflexionseinrichtung zurückreflektierte sekundäre Signal gegenüber dem primären optoelektronischen Signal impulsmoduliert sein.

Bei einer mechanisch ausgebildeten Anordnung der Reflexionseinrichtung des erfindungsgemäßen optischen Schalters kann die Reflexionseinrichtung wenigstens einen mechanisch beweglichen, insbesondere schwingungsfähigen Spiegel aufweisen, wobei die Modulationsfrequenz des sekundären optoelektronischen Signales der Schwingungsfrequenz des Spiegels entspricht. Am Ausgang der Übertragungsstrecke ist beispielsweise ein einziger schwingungsfähiger Spiegel vorgesehen, der beim Schaltvorgang angeregt wird, wobei die Rückreflexion des Lichtsignales in die (einzige) Faser periodisch entsprechend der Eigenfrequenz oder einer von außen aufgezwungenen Frequenz des Spiegels moduliert wird. Auf diese Weise kann auf der Senderseite, die beispielsweise aus einer Leuchtdiode und einem Phototransistor besteht, mittels geeigneter elektrischer Schaltungen das reflektierte Lichtsignal des primären (ruhenden) vom reflektierten sekundären Lichtsignal des schwingenden Spiegels getrennt werden. Das elektrische Wechselsignal, das durch den modulierten Anteil des reflektierten Lichtsignals beispielsweise in einem Phototransistor hervorgerufen wird, kann anschließend zur Auslösung eines Schaltvorganges benutzt werden.

Da die Eigenfrequenz des Spiegels über die Geometrie und das Material in an sich bekannter Weise einstellbar ist, sind darüber hinaus auch Ausführungen mit einer Vielzahl von Spiegeln realisierbar, die jeweils eine unterschiedliche Eigenfrequenz besitzen und demgemäß unterschiedlich sekundäre, modulierte Lichtsignale erzeugen, die eine Darstellung von mehreren Schaltzuständen ermöglichen. Diese können beispielsweise durch geeignete Trennfilter auf der Eingangsseite oder auf elektronischem Wege durch geeignete Schaltungsmaßnahmen voneinander getrennt werden. Vermittels einer der Verstellung der Reflexionseinrichtung zugeordneten Schalteinrichtung, beispielsweise in der Form eines Drehschalters, bei dem jede Schaltposition mit einem Spiegel unterschiedlicher Eigenfrequenz ausgestattet ist, läßt sich ein bestimmter ausgewählter Spiegel in den oder aus dem Strahlengang der optischen Übertragungsstrecke positionieren.

Die Anregung der Schwingung des wenigstens einen Spiegels kann auf mechanischem Wege, aber auch elektrisch oder magnetisch erfolgen. Es ist beispielsweise auch möglich, einen magnetisch empfindlichen Spiegel in eine durch ein externes magnetisches Wechselfeld erzwungene periodische Schwingung, also abweichend von der Eigenfrequenz, in den Strahlengang des optischen Übertragungsmediums zu versetzen.

Bei einer weiteren, optoelektronischen Realisierung des erfindungsgemäßen optischen Schalters kann vorgesehen sein, daß die Reflexionseinrichtung an Stelle eines Spiegels wenigstens einen Photohalbleiter aufweist, vorzugsweise eine Photodiode aus einem direkten Halbleiter, z.B. aus GaAs, InP oder anderen binären, ternären oder quaternären direkten Halbleitern. Bei der Bestrahlung mit Licht mit einer Wellenlänge von kleiner oder gleich der Bandlückenwellenlänge werden im Halbleiterinneren Elektron- und Lochpaare erzeugt.

Bei offenem Stromkreis rekombinieren die Ladungsträger unter Abgabe eines Photons der Wellenlänge $\lambda = 1{,}24/E_g \, (\mu m)$, wobei $E_g$ die Energielücke des Halbleiters bezeichnet. Wird beispielsweise als Strahlungsquelle ein Halbleiterlaser mit einer Emissionswellenlänge von 850 nm und als Reflexionseinrichtung eine GaAs-Photodiode verwendet, so emittiert diese Photodiode bei Bestrahlung ein Lichtsignal mit der Peakwellenlänge von etwa 900 nm. Diese beiden Wellenlängen sind durch geeignete Filter auf der Eingangsseite der optischen Übertragungsstrecke trennbar, so daß das primäre Laserlicht vom sekundären Photodiodenlicht getrennt werden kann.

Wird hierbei die am ausgangsseitigen Ende der optischen Übertragungsstrecke befindliche Photodiode in den Strahlengang des primären Lichtsignals versetzt, so wird in dieser Photodiode eine Lichtstrahlung mit der Wellenlänge der Photodiode erzeugt und in den Lichtwellenleiter eingekoppelt, an einem am eingangsseitigen Ende der Übertragungsstrecke angeordneten Trennspiegel reflektiert und von einer Empfängerphotodiode detektiert. Befindet sich die Photodiode am ausgangsseitigen Ende der Übertragungsstrecke außerhalb des Strahlenganges des primären Lichtsignals, so wird von der empfängerseitigen Photodiode kein Signal angezeigt. Durch Bewegen der ausgangsseitigen Photodiode in den oder aus dem Strahlengang des primären Lichtsignals kann somit ein Schaltvorgang durch die empfängerseitige Photodiode ausgelöst werden.

Die erfindungsgemäße Anordnung läßt sich insbesondere auch zur Überwachung von Lichtwellenleitern im Hinblick darauf, ob eine Leitungsunterbrechung vorliegt oder nicht, benutzen, so daß beispielsweise eine der Anordnung zugeordnete Schaltungsanlage immer dann selbsttätig abgeschaltet wird, wenn bei der empfängerseitigen Photodiode kein Signal ankommt. Eine solche Anordnung kann insbesondere bei Endabschaltern vorteilhaft eingesetzt werden.

Die als Strahlungsquelle am eingangsseitigen Ende der optischen Übertragungsstrecke beispielhaft verwendete Laserdiode oder Leuchtdiode kann kontinuierlich (c-w-Betrieb) oder gepulst betrieben werden. Bei langsameren Schaltvorgängen ist ein Pulsbetrieb (mit beispielsweise langen Pausen) von Vorteil, da hierbei die Belastung der Sendebauelemente gesenkt und dadurch deren Lebensdauer verlängert wird, und sich elektronische Schaltungen störunempfindlicher gestalten lassen.

Weitere Merkmale, Vorteile und Zweckmäßigkeiten der vorliegenden Erfindung ergeben sich aus der Beschreibung von Ausführungsbeispielen anhand der Zeichnung. Es zeigt:

Figur 1 einen optischen Schalter mit nur einer Faser gemäß einem ersten Ausführungsbeispiel der Erfindung,

Figur 2 einen optischen Schalter mit nur einer Faser gemäß einem zweiten Ausführungsbeispiel der Erfindung, und

Figur 3A bzw. Figur 3B eine schematische Darstellung einer Halbleiter-Photodiode zur Erläuterung des zugrunde liegenden physikalischen Prinzips bei offenem bzw. geschlossenem Schalter.

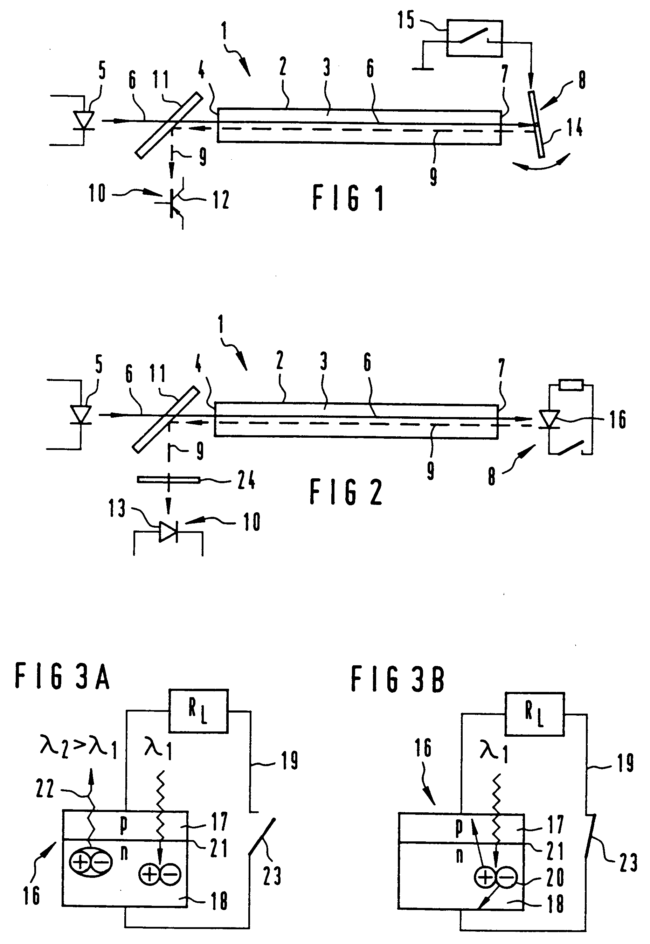

Bei den in der Zeichnung dargestellten Ausführungsbeispielen besitzt der optische Schalter 1 eine optische Übertragungsstrecke 2, die ein optisches Übertragungsmedium 3 mit lediglich einer einzigen Faser als Lichtwellenleiter aufweist. Dem eingangsseitigen Ende 4 der optischen Übertragungsstrecke 2 ist eine Strahlungsquelle 5, vorzugsweise ein Halbleiterlaser oder eine Halbleiterphotodiode zugeordnet, welche ein primäres Lichtsignal 6 aussendet. Das primäre Lichtsignal 6 wird in die Übertragungsstrecke 2 eingekoppelt und einer am ausgangsseitigen Ende 7 der Übertragungsstrecke 2 angeordneten Reflexionseinrichtung 8 zugeführt. Vermittels der Reflexionseinrichtung 8 wird das primäre optoelektronische Signal 6 in ein sekundäres, moduliertes optoelektronisches Signal 9 umgewandelt, welches in die optische Übertragungsstrecke 2 zurück eingekoppelt und über einen am eingangsseitigen Ende 4 der Übertragungsstrecke 2 angeordneten Trennspiegel 11, der für das primäre Lichtsignal 6 durchlässig ist, an einen Empfänger 10 übertragen. Der Empfänger 10 kann beispielsweise wie bei der Ausführungsform gemäß Fig. 1 einen Phototransistor 12 oder wie beispielsweise bei der Ausführungsform gemäß Fig. 2 eine Photodiode 13 aufweisen. In jedem Fall spricht der Empfänger 10 auf das empfangene sekundäre Lichtsignal 9 an und löst vermittels einer (nicht näher dargestellten) elektronischen Schaltung einen Schaltvorgang aus, beispielsweise zur Ansteuerung weiterer (nicht näher dargestellter) Schaltkreise.

Bei dem ersten Ausführungsbeispiel gemäß Fig. 1 besitzt die Reflexionsvorrichtung 8 am Ausgang der Übertragungsstrecke 2 einen schwingungsfähigen Spiegel 14, der beim Schaltvorgang derart angeregt wird, daß die Rückreflexion des Lichtsignales in die Faser periodisch entsprechend der Eigenfrequenz des Spiegels 14 oder einer von außen aufgezwungenen Frequenz des Spiegels 14 moduliert wird. Auf diese Weise kann auf der Senderseite mittels geeigneter (nicht näher dargestellter) elektrischer Schaltungen das reflektierte Licht des primären (ruhenden) vom reflektierten Licht des schwingenden Spiegels 14 getrennt werden. Das elektrische Wechselsignal, das durch den modulierten Anteil des reflektierten Lichtes in dem Fototransistor 12 hervorgerufen wird, kann dann zur Auslösung eines Schaltvorganges benutzt werden. Die Eigenfrequenz des Spiegels 14 kann über die Geometrie und das Material des Spiegels einstellbar sein. Des weiteren sind beispielsweise auch Drehschalter, bei dem jede Schaltposition mit einem Spiegel unterschiedlicher Eigenfrequenz ausgestattet ist, realisierbar.

Die Anregung der Schwingung des Spiegels 14 kann mechanisch, aber auch elektrisch oder magnetisch erfolgen. Es ist beispielsweise möglich, einen magnetisch empfindlichen Spiegel in eine durch ein externes magnetisches Wechselfeld erzwungene periodische Schwingung, also abweichend von der Eigenfrequenz, zu versetzen.

In Fig. 2 ist ein zweites Ausführungsbeispiel der Erfindung dargestellt, bei dem anstelle eines Spiegels eine Photodiode 16 aus einem direkten Halbleiter, beispielsweise aus GaAs, InP, oder anderen binären, ternären oder quaternären direkten Halbleitern vorgesehen ist.

Die Funktionsweise der Photodiode 16 wird anhand der schematischen Darstellung gemäß Fig. 3A und Fig. 3B erläutert.

Bei Bestrahlung der Photodiode 16 mit Licht werden im Halbleiterinneren Elektron-Lochpaare generiert. Ist die Anode 17 und die Kathode 18 der Diode 16 gemäß Fig. 3B über einen äußeren Stromkreis 19 kurzgeschlossen, so werden die Elektron-Lochpaare 20 durch das innere Feld am pn-Übergang 21 getrennt und es fließt über den äußeren Stromkreis ein Strom Ip. Bei offenem Stromkreis gemäß Fig. 3A rekombinieren die durch die Photonen erzeugten Elektron-Lochpaare wieder. Die dabei freiwerdende Energie wird bei einem indirekten Halbleiter (wie Si) an das Gitter abgegeben. Der Halbleiter erwärmt sich letztlich. Bei einem direkten Halbleiter wie z.B. GaAs wird bei der Rekombination eines Elektron-Lochpaares die Energie in Form eines Photons 22 abgegeben. Durch Auf- und Zumachen des Schalters 23 im äußeren Stromkreis 19 kann die Diode 16 bei konstanter Bestrahlung ein optisches Wechselsignal entsprechend der Schaltfrequenz senden. Die Energie für die emittierten Photonen 22 stammt allein von den absorbierten Photonen des primären Lichtsignals 6. Wir haben es hier mit einem O/O-Wandler zu tun (O=Optisch). GaAs hat entsprechend der Bandlücke einen Emissionspeak bei etwa 900 nm, d.h. nur Licht gleich oder kleiner 900 nm kann Elektron-Lochpaare erzeugen. Wählt man nun eine Lichtquelle 5, die deutlich unter 900 nm (z.B. 800 nm) liegt, so lassen sich die beiden Wellenlängen problemlos optisch trennen, beispielsweise vermittels eines geeigneten Filters 24, der dem Empfänger 10 vorgeschaltet ist, und Licht mit einer Wellenlänge unterhalb eines Grenzwertes blokkiert.

**Patentansprüche**

1. Optischer Schalter mit einer optischen Übertragungsstrecke (2), die ein optisches Übertragungsmedium (3) aufweist, einer dem eingangsseitigen Ende (4) der optischen Übertragungsstrecke (2) zugeordneten Strahlungsquelle (5) zum Aussenden eines primären optoelektrischen Signals (6), welches in die Übertragungsstrecke (2) eingekoppelt wird, und einer dem ausgangsseitigen Ende (7) der Übertragungsstrecke (2) zugeordneten Reflexionseinrichtung (8), an welche das primäre optoelektronische Signal (6) zugeführt und in die Übertragungsstrecke (2) zurück reflektiert wird, **dadurch gekennzeichnet**, daß die Reflexionseinrichtung (8) das primäre optoelektronische Signal (6) in ein sekundäres moduliertes optoelektronisches Signal (9) wandelt, das sekundäre modulierte optoelektronische Signal (9) in die optische Übertragungsstrecke (2) zurück einkoppelt und an einen dem eingangsseitigen Ende (4) der Übertragungsstrecke (2) zugeordneten Empfänger (10) überträgt, der auf das sekundäre modulierte optoelektronische Signal (9) zur Ausführung eines elektronischen Schaltvorgangs anspricht.

2. Optischer Schalter nach Anspruch 1, **dadurch gekennzeichnet**, daß das optische Übertragungsmedium (3) der optischen Übertragungsstrecke (2) einen Lichtwellenleiter mit lediglich einer einzigen Faser darstellt.

3. Optischer Schalter nach Anspruch 1 oder 2, **dadurch gekennzeichnet**, daß dem am eingangsseitigen Ende (4) der Übertragungsstrecke (2) angeordneten Empfänger (10) eine optische Trennvorrichtung (11, 24) zugeordnet ist, welche auf das primäre optoelektronische Signal (6) der Strahlungsquelle (5) und das sekundäre modulierte optoelektronische Signal (9) von der Reflexionseinrichtung (8) unterschiedlich anspricht.

4. Optischer Schalter nach Anspruch 3, **dadurch gekennzeichnet**, daß die optische Trennvorrichtung (11, 24) ein optoelektronisches Filter (24) aufweist, welches im wesentlichen lediglich für das sekundäre modulierte optoelektronische Signal (9) durchlässig ist.

5. Optischer Schalter nach Anspruch 1 bis 4, **dadurch gekennzeichnet**, daß dem am eingangsseitigen Ende (4) der Übertragungsstrecke (2) angeordneten Empfänger (10) ein Schaltkreis zugeordnet ist, der als Reaktion auf das vom Empfänger (10) erfaßte sekundäre modulierte optoelektronische Signal (9) ein Steuersignal zur Ausführung des elektronischen Schaltvorgangs ableitet.

6. Optischer Schalter nach Anspruch 1 bis 5, **dadurch gekennzeichnet**, daß das von der Reflexionseinrichtung (8) zurückreflektierte sekundäre Signal (9) gegenüber dem primären optoelektronischen Signal (6) impulsmoduliert ist.

7. Optischer Schalter nach Anspruch 1 bis 6, **dadurch gekennzeichnet**, daß die Reflexionseinrichtung (8) wenigstens einen mechanisch beweglichen, insbesondere schwingungsfähigen Spiegel (14) aufweist, und die Modulationsfrequenz des sekundären optoelektronischen Signales (9) der Schwingungsfrequenz des Spiegels (14) entspricht.

8. Optischer Schalter nach Anspruch 7, **dadurch gekennzeichnet**, daß die Schwingungsfrequenz des Spiegels (14) im wesentlichen die Resonanzfrequenz des Spiegels ist.

9. Optischer Schalter nach Anspruch 7, **dadurch gekennzeichnet**, daß die Schwingungsfrequenz des Spiegels (14) eine von außen aufgezwungene Frequenz abweichend von der Resonanzfrequenz des Spiegels ist.

10. Optischer Schalter nach Anspruch 7 bis 9, **dadurch gekennzeichnet**, daß der Antrieb bzw. die Steuerung für die Anregung der Spiegelbewegung bzw. -schwingung mechanisch, elektrisch oder magnetisch erfolgt.

11. Optischer Schalter nach Anspruch 7 bis 10, **dadurch gekennzeichnet**, daß die Reflexionseinrichtung (8) eine Vielzahl von Spiegeln unterschiedlicher Resonanzfrequenz aufweist, und jeweils ein ausgewählter Spiegel vermittels einer der Verstellung der Reflexionseinrichtung (8) zugeordneten Schalteinrichtung in den oder aus dem Strahlengang der optischen Übertragungsstrecke (2) positionierbar ist.

12. Optischer Schalter nach Anspruch 1 bis 11, **dadurch gekennzeichnet**, daß die Reflexionseinrichtung (8) wenigstens einen Photohalbleiter (16) aufweist, der nach Bestrahlung mit dem primären optoelektrischen Signal (6) durch Erzeugung und Rekombination von Elektron- und Lochpaaren das sekundäre modulierte optoelektrische Signal (9) insbesondere mit einer anderen Emissionswellenlänge als des primären optoelektrischen Signals (6) aussendet.

13. Optischer Schalter nach Anspruch 12, **dadurch gekennzeichnet**, daß der wenigstens eine Photohalbleiter (16) vermittels einer Schaltvorrichtung in den oder aus dem Strahlengang der optischen Übertragungsstrecke (2) bringbar ist.

14. Optischer Schalter nach Anspruch 1 bis 13, **dadurch gekennzeichnet**, daß die Reflexionseinrichtung (8) eine Vielzahl von Photohalbleitern aufweist, die unterschiedliche Emissionswellenlängen besitzen.

FIG 1

FIG 2

FIG 3A

FIG 3B

$R_L$

$\lambda_2 > \lambda_1$  $\lambda_1$

$R_L$

$\lambda_1$